# EUROPEAN PATENT APPLICATION

(11) **EP 4 521 464 A1**
(43) Date of publication of application: **12.03.2025**
(21) Application number: 23196309.1
(22) Date of filing: 08.09.2023
(51) Int. Cl.: H01L 27/02, H01L 29/775, H10B 10/00, H01L 21/8234, H01L 27/06, H01L 29/06

(54) **A METHOD FOR FORMING A SEMICONDUCTOR DEVICE, AND A SEMICONDUCTOR DEVICE**

(71) Applicant: Imec VZW, 3001 Leuven (BE)
(72) Inventor: Chan, Boon Teik, 3012 Wilsele (BE); Salahuddin, Shairfe Muhammad, 3010 Kessel Lo (BE)
(74) Representative: AWA Sweden AB

(57) **Abstract**

A method for forming a semiconductor device (1), the method comprising:
forming a plurality of stacks of layers (10a, 10b) on a substrate (4), the stacks of layers being laterally spaced apart;
converting each stack of layers (10a, 10b) into a stack of field-effect transistors (60a, 60b), FETs, each stack of FETs (60a, 60b), comprising a first FET (61) at the lower section (15a, 15b) of the stack of layers (10a, 10b) and a second FET (62) at the upper section (16a, 16b) of the stack of layers (10a, 10b), the first stack of layers (10a) being converted into a first stack of FETs (60a), the first (61) and second (62) FETs of the first stack of FETs being p-type FETs, the second stack of layers (10b) being converted into a second stack of FETs (60b), the first (61) and second (62) FETs of the second stack of FETs (60b) being n-type FETs.

## Description

### TECHNICAL FIELD

The present disclosure relates to a semiconductor device and a method for forming the semiconductor device.

### BACKGROUND

To enable more area- and power-efficient circuits, vertical semiconductor device structures are receiving increasing attention as an alternative to traditional planar semiconductor devices. One notable example is stacked transistor devices comprising a complementary pair of field effect transistors (FETs) stacked on top of each other, i.e. a p-type FET (pFET) on top of a n-type FET (nFET) or vice versa.

### SUMMARY

It is an object of the present inventive concept to enable a compact semiconductor device. In particular, it is an object to enable a compact static random-access memory. It is a further objective of the present inventive concept to facilitate easy and/or low cost manufacturing of the semiconductor device. These and other objectives of the inventive concept are at least partly met by the invention as defined in the independent claims. Preferred embodiments are set out in the dependent claims.

According to a first aspect there is provided a method for forming a semiconductor device, the method comprising:
forming a plurality of stacks of layers on a substrate, the stacks of layers being laterally spaced apart, each stack of layers comprising channel layers of semiconductor material separated by sacrificial layers, the plurality of stacks of layers comprising at least a first stack of layers and a second stack of layers, each stack of layers having a lower and an upper section, the lower and upper section each comprising at least one channel layer;
forming, for each stack of layers, a dielectric layer associated with the stack of layers, the dielectric layer comprising:
   a first portion arranged between the lower and upper section of the associated stack of layers; and
   a second portion extending laterally from a side of the associated stack of layers, the second portion being supported by a sacrificial structure;
for the respective upper sections of the first and second stacks of layers:
   forming a gate extending above, to the side, and below the at least one channel layer of the upper section, said gate replacing sacrificial layers above and below the at least one channel layer of the upper section;
for the respective lower sections of the first and second stack of layers:
   forming another gate extending above, to the side, and below the at least one channel layer of the lower section, said gate replacing sacrificial layers above and below the at least one channel layer of the lower section and the sacrificial structure supporting the second portion of the dielectric layer, wherein the gate of the lower section and the gate of the upper section comprise electrical contacts on vertically opposite sides of the stack of layers;
   converting each stack of layers into a stack of field-effect transistors, FETs, each stack of FETs, comprising a first FET at the lower section of the stack of layers and a second FET at the upper section of the stack of layers, the first stack of layers being converted into a first stack of FETs, the first and second FETs of the first stack of FETs being p-type FETs, the second stack of layers being converted into a second stack of FETs, the first and second FETs of the second stack of FETs being n-type FETs.

According to a second aspect there is provided a semiconductor device, arranged on a substrate, the semiconductor device comprising at least a first and a second stack of field effect transistors, FETs, each stack of FETs comprising
a first FET and a second FET stacked on top of the first FET, each of the first and second FET comprising at least one channel layer for charge transport and a gate, the gate extending above, to the side, and below the at least one channel layer, wherein the channel layers of the first and second FETs are parallel with each other and parallel with the substrate;
wherein, for each of the first and second stack of FETs,
   the gates of the first and second FET are separated by a dielectric layer;
   the gates of the first FET and second FET comprise electrical contacts on vertically opposite sides of the stack of FETs;
wherein the first and second FETs of the first stack of FETs are p-type FETs and the first and second FETs of the second stack of FETs are n-type FETs.

In accordance with the above, the method according to the first aspect may form the semiconductor device according to the second aspect. Advantages described in conjunction with the first aspect may be equally applicable to the second aspect, and vice versa.

As mentioned, the FETs of the first stack of FETs are p-type FETs and the FETs of the second stack of FETs are n-type FETs. The term p-type FET may herein refer to a FET having p-doped source/drain regions. The term n-type FET may herein refer to a FET having n-doped source/drain regions. In the following, the term pFET will be used interchangeably with p-type FET and the term nFET will be used interchangeably with n-type FET. The channel layer of a FET may be undoped or have a doping opposite to the doping of the source/drain regions of said FET.

The inventors have realized that, for at least some types of semiconductor devices, it is advantageous to stack FETs of the same type on top of each other.

Stacking FETs provides a compact semiconductor device. Stacking FETs of the same type on top of each other facilitates processing customized to the FET type. For example, nFETs may be provided with a different (e.g. larger) channel layer width than pFETs. This may be hard to achieve when an nFET and a pFET are comprised in the same stack of FETs. As will be discussed below, the invention facilitates a compact semiconductor device since pFETs stacked on top of each other may be made with small channel layer width, giving a small footprint, while nFETs stacked on top of each other may be made with a slightly larger channel layer width to boost the nFET performance. In other words, the pFET channel layer width may not necessarily be limited by the minimum nFET channel layer width.

Further, stacking FETs of the same type on top of each other enables compact connections between FETs, thereby enabling a compact semiconductor device. For example, stacking FETs of the same type on top of each other enables connections already in a front-end-of-line portion of the semiconductor device, in contrast to making the connections through interconnects in a back-end-of-line portion of the semiconductor device.

As a first example, the source or drain region of one FET in a stack of FETs may be directly connected to the source or drain region of another FET in the same stack of FETs, e.g. by epitaxially merging. As a second example, the gate of one FET in a stack of FETs may be directly connected to the gate of another FET. Thus, two FETs in a stack of FETs may have a common gate. In the above, "directly connected" refers to being connected at the same vertical height as the stack of FETs.

Connections between FETs in the front-end-of-line portion of the semiconductor device relaxes requirements on interconnects in the back-end-of-line portion of the semiconductor device which in turn enables a compact semiconductor device. In other words, connections between FETs in the front-end-of-line portion of the semiconductor device may alleviate routing congestion in the back-end-of-line portion of the semiconductor device.

Further, easy and/or cheap manufacturing (e.g. easy back-end-of-line processing) is facilitated. For example, when interconnect levels of the back-end-of-line portion of the semiconductor device are not congested, it may be possible to manufacture interconnects with simple and inexpensive lithography such as single print patterning instead of more complex and costly lithography methods such as self-aligned double patterning (SADP) or self-aligned quadruple patterning (SAQP).

One semiconductor device where it is particularly advantageous to have FETs of the same type stacked on top of each other is a static random access memory (SRAM) cell. Thus, the semiconductor device may be a SRAM cell.

Thus, the method of the first aspect may comprise
forming a latching circuit configured to store one bit by connecting FETs of the stacks of FETs. Thereby, a SRAM cell may be formed.

In the following, the method for forming the semiconductor device will be discussed. Features of the final semiconductor device, according to the second aspect, will be discussed in conjunction with the processing steps of the first aspect.

Each stack of layers may be seen as a fin comprising a plurality of layers. Each stack of layers, e.g. each fin, may comprise two opposing lateral side faces, two opposing lateral end faces, and a top face. A bottom face of each stack of layers may be facing the substrate.

Forming the plurality of stacks of layers may comprise providing, e.g. epitaxially growing, a plurality of layers on the substrate and patterning fins out of said plurality of layers. Channel layers and sacrificial layers may comprise Si and/or Ge. Channel layers and sacrificial layers may have different compositions. Thereby, selective etching of sacrificial layers is enabled. In particular, channel layers may comprise Si (e.g. solely Si) and sacrificial layers may comprise SiGe. For each stack of layers, a sacrificial layer between the lower and the upper section may have a different SiGe composition than sacrificial layers within the lower and/or upper section. Thereby, different etch rates of the layers with different SiGe composition is enabled. Channel layers may be referred to as nanosheets.

The sacrificial structure may act as part of a replacement gate. Thus, the gates may be produced in a gate-last process. In other words, the sacrificial structure may act as a dummy gate.

The sacrificial structure may comprise amorphous silicon or polycrystalline silicon.

The sacrificial structure may comprise material deposited in a trench between one of the side faces of the stack of layers and an isolation wall. Material for the sacrificial structure may be deposited up to a level above the first portion of the dielectric layer. The material for the sacrificial structure may subsequently be etched back to the level of the first portion of the dielectric layer.

As mentioned, the stacks of layers are laterally spaced apart. After the stacks of layers have been formed, they may be separated by an empty space or gap.

Converting a stack of layers into a stack of field-effect transistors may comprise forming source/drain regions at opposite ends of the channel layers for both the upper and lower section. The source/drain regions may be doped semiconductor regions, e.g. doped semiconductor regions adjacent to the lateral end faces of the stack of layers, e.g. doped semiconductor regions epitaxially grown on the lateral end faces of the stack of layers. For example, a p-doped semiconductor may be grown on the lower section of the first lateral end face of the first stack of layers to form a source region and a p-doped semiconductor may be grown on the lower section of the second lateral end face of the first stack of layers to form a drain region. Thereby, source/drain regions of the first FET (being a pFET) of the first stack of layers is formed. Source/drain regions of the second FET (also being a pFET) of the first stack of layers may be formed correspondingly by growing on the upper sections of the lateral end faces of the first stack of layers. Source/drain regions of the first and second FET of the second stack of layers may be formed in a similar manner, wherein n-doping is used instead of p-doping (to form nFETs).

Source/drain regions may be formed before or after the gates are formed. Forming source/drain regions before forming the gate, i.e. in a gate-last process, is advantageous. The gates may comprise metal.

A dielectric layer associated with the stack of layers, as described above, may facilitate electrical separation of the gates of the FETs of the same stack of layers. The dielectric layer may be formed for all stacks of layers of the semiconductor device. For the stacks of layers where a common gate is preferred, at least part of the dielectric layer, e.g. at least part of the second portion of the dielectric layer, may later be replaced by an electrical conductor, e.g. a metal, e.g. gate material. The first portion of the dielectric layer may be referred to as middle dielectric isolation (MDI).

The gates or gate stacks may comprise a gate dielectric layer followed by a gate work function metal (WFM) conformally coating the channel layers of the respective upper and lower section. As mentioned, the gate of a section extends above, to the side, and below the at least one channel of the said section.

In the final semiconductor device, the channel layers and the gate may form a forksheet arrangement or a gate all around (GAA) arrangement.

In the forksheet arrangement, the gate may extend above, on one side, and below the at least one channel layer of the FET. The remaining side of the at least one channel layer may adjoin a dielectric wall.

In the GAA arrangement, the gate may extend also on the above mentioned remaining side of the at least one channel layer. Thus, in this case the gate may extend around the at least one channel layer.

Forming gates may be done by conformal deposition. Prior to the gate being formed, sacrificial layers that the gate is intended to replace may be removed, e.g. by etching, e.g. by selective etching.

As mentioned, the gate of the lower section and the gate of the upper section comprise electrical contacts on vertically opposite sides of the stack of layers. Thus, for each stack of FETs the gates may be contacted both from above and from below. For example, the first FET (of the lower section) may be contacted to a back side power delivery network, e.g. to a buried power rail (BPR) while the second FET (of the upper section) may be contacted to a front side power delivery network, or vice versa. Electrical contacts on vertically opposite sides of the stack of layers facilitates a compact semiconductor device.

As indicated above, the channel layers of the second stack of layers may be wider than the channel layers of the first stack of layers. Thus, the second stack of layers may be wider than the first stack of layers.

At a given channel layer width, a pFET generally performs better than a nFET, the pFET may e.g. switch faster than the nFET. If all pFETs and nFETs of a semiconductor device are made with the same channel layer width, the performance of the nFET may define the minimum channel layer width. In such a case, the pFET may be larger than necessary. In contrast, in a semiconductor device according to the invention, the pFET channel layer width may not necessarily be limited by the minimum nFET channel layer width, such that the pFET channel layer width may be smaller than the nFET channel layer width. Thereby saving space. It may further be advantageous to balance nMOS and pMOS performance, e.g. balance their switching speed.

In view of the above, for the semiconductor device according to the second aspect, the channel layers of the second stack of FETs may be wider than the channel layers of the first stack of FETs.

In the following, the dielectric layer associated with each stack of layers will be discussed.

For each stack of layers, the first and second portion of the associated dielectric layer may be made of different materials. This facilitates production of a common gate. For example, this facilitates removal of the second portion by selective etching. The first and second portion of the associated dielectric layer may have different compositions and/or different crystallinity. The first portion of the associated dielectric layer may comprise silicon nitride (Si₃N₄) or/and silicon oxycarbide (SiOC) or/and silicon oxycarbonitride (SiOCN) or/and SiON, or/and SiBCN. The first portion of the associated dielectric layer may comprise silicon oxide, e.g. oxidized polysilicon.

In view of the above, in the semiconductor device according to the second aspect, for each stack of FETs, the dielectric layer may comprise:
a first portion between the at least one channel layer of the first FET and the at least one channel layer of the second FET; and
a second portion between the gate extending to the side of the at least one channel layer of the first FET and the gate extending to the side of the at least one channel layer of the second FET;
wherein the first and second portion of the dielectric layer are made of different materials.

In the final semiconductor device, according to the second aspect, a stack of FETs where the second portions of the dielectric layer remain may be seen as a stack of FETs where the first and second FET have separate gates. A stack of FETs where the second portions of the dielectric layer is removed (and thus not present anymore) may be seen as a stack of FETs where the first and second FET have a common gate. The method according to the first aspect may be used to produce semiconductor devices where all stacks of FETs have separate gates for the first and second FET or to produce semiconductor devices where some or all stacks of FETs have common gates for the first and second FET.

For each stack of layers, forming the dielectric layer associated with the stack of layers may comprise:
forming the first portion of the dielectric layer by replacing a sacrificial layer of the stack of layers with dielectric material. The sacrificial layer being replaced may herein be a sacrificial layer between the upper and lower section of the stack of layers. Forming the first portion of the dielectric layer may comprise removing, e.g. etching away, the sacrificial layer; followed by depositing the first portion of the dielectric layer, thereby replacing the sacrificial layer. The sacrificial layer between the upper and lower section of the stack of layers may have a composition different from the composition of sacrificial layers within the upper and lower section of the stack of layers. Thereby, an etch providing selectivity between the sacrificial layers within the upper and lower section and the sacrificial layer between the upper and lower section may be used to remove the sacrificial layer between the upper and lower section at a different time from the sacrificial layers within the upper and lower section. For example, the sacrificial layer between the upper and lower section of the stack of layers may comprise SiGe with high at.% Ge (e.g. 30-50 at.% Ge) and the sacrificial layers within the upper and lower section of the stack of layers may comprise SiGe with low at.% Ge (e.g. 10-20 at.% Ge). Thereby, an etch with an etch rate dependent on the Ge/Si ratio may be used to remove the sacrificial layer between the upper and lower section while leaving most of the sacrificial layers within the upper and lower section intact. These may be removed at a later time.

For each stack of layers, forming the dielectric layer associated with the stack of layers may comprise:
forming the second portion of the dielectric layer by:
providing material for the sacrificial structure, up to a level of the first portion of the dielectric layer;
oxidizing a top layer of the material provided for the sacrificial structure to form the second portion of the dielectric layer supported by the sacrificial structure.

The material for the sacrificial structure may be provided by deposition, e.g. deposition in a trench between one of the side faces of the stack of layers and an isolation wall. The material for the sacrificial structure may be deposited up to a level above the first portion of the dielectric layer, e.g. to the top of the stack of layers, and then etched back to the level of the first portion of the dielectric layer. The material for the sacrificial structure may comprise amorphous silicon or polycrystalline silicon. Thus, a top layer of amorphous silicon or polycrystalline silicon may be oxidized.

An alternative to the above mentioned formation of the second portion of the dielectric layer may be to provide a dielectric up to a level of the first portion of the dielectric layer, e.g. by fill and etch back. In this case, the sacrificial structure below the second portion of the dielectric layer may also be a dielectric, which may be replaced by a gate.

In the following, source/drain regions will be discussed.

The method of the first aspect may comprise:
forming, by epitaxial growth, for each section of each stack of layers, source/drain regions being arranged at opposite ends of the channel layers of the sections,
wherein a dielectric spacer is formed on top of source/drain regions at the lower section before source/drain regions at the upper section are formed.

Accordingly, the device of the second aspect may comprise source/drain regions being arranged at opposite ends of the channel layers of the sections,
wherein, for at least one stack of FETs, the source/drain region at the lower section is separated from the source/drain region at the upper section by a dielectric spacer.

When a source/drain region at the lower section is separated from a source/drain region at the upper section by a dielectric spacer, said source/drain regions may be separate. Thus, said source/drain region may be contacted individually.

Additionally or alternatively, some source/drain regions may be merged, e.g. epitaxially merged, as discussed below.

In the method of the first aspect,
for at least one stack of layers, the dielectric spacer at the lower section may be removed again at one end of the channel layers before source/drain regions at the upper section are formed, such that, at said end of the channel layers, the source/drain regions are epitaxially merged.

Accordingly, for the semiconductor device of the second aspect, at one end of the channel layers of one stack of layers, the source/drain region at the lower section may be epitaxially merged with the source/drain region at the upper section.

Merged source/drain regions may have a common contact, i.e. one single contact may be used for the merged source/drain regions. As previously mentioned, merged source/drain regions may alleviate congestion in the back-end-of-line portion of the semiconductor device.

In the method of the first aspect, the plurality of stacks of layers may comprise a third stack of layers, the third stack of layers being converted into a third stack of FETs, wherein the method comprises:
providing a common gate of the first and second FETs of the third stack of FETs by, for the third stack of layers:
removing the second portion of the dielectric layer extending laterally from the side of the third stack of layers; and
forming a gate extending above, to the side, and below the at least one channel layer of the both the lower and upper sections of the third stack of layers, such that said gate simultaneously controls the channel layers of both the lower and upper sections of the third stack of layers, said gate replacing sacrificial layers above and below each channel layer of the lower and upper sections and the sacrificial structure previously supporting the removed second portion of the dielectric layer.

Accordingly, the semiconductor device of the second aspect may comprise a third stack of FETs,
wherein, the first and second FET of the third stack of FETs have a common gate.

The common gate may be interconnected to another part of the semiconductor device by a common contact.

As previously mentioned, common gates may alleviate congestion in the back-end-of-line portion of the semiconductor device.

It should be understood that the gate of the lower section of the stack of layers may be formed by backside processing. Backside processing herein refers to any processing wherein the lower section of the stack of layers is accessed from a backside of the substrate.

Thus, the method may comprise:
removing at least part of the substrate from a backside, the backside being a side of the substrate opposite to the plurality of stacks of layers;
wherein, for any one (or all) of the respective lower sections of the first, second, or third stack of layers, forming the gate of the lower section is done from the backside after removing said part of the substrate.

It may be particularly useful to form the gate of the lower section of the first and second stack of layers from the backside.

The method of the first aspect may further comprise
forming a dielectric wall, the dielectric wall adjoining one stack of layers to the left and another stack of layers to the right, such that a pair of stacks of layers is formed with the dielectric wall in between;
wherein, for each stack of layers of the pair of stacks of layers, the gates of the lower and upper sections are formed to extend to the side of the stack of layers that is opposite to the dielectric wall.

Thus, the pair of stacks of FETs, converted from the pair of stacks of layers, may form a forksheet arrangement.

It is advantageous if all FETs of the pair of stacks of FETs are of the same type. Thus,
all FETs of the pair of stacks of FETs may be p-type; or
all FETs of the pair of stacks of FETs may be n-type.

The FETs in a forksheet arrangement may be very close. Thus, doping may be easier if all FETs of the pair of stacks of FETs are of the same type. Further, if different channel layer widths are used for pFETs and nFETs, a symmetric forksheet arrangement may still be achieved if all FETs of the pair of stacks of FETs are of the same type.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figs 1 and 2a-c illustrate a semiconductor device
Figs 3a-b to 8a-b illustrate a method for forming a semiconductor device, according to some embodiments.

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

In the following, the invention will be illustrated in the case where the semiconductor device 1 is a SRAM cell 2. The invention is particularly advantageous in the case of SRAM cells 2. However, the invention is also applicable to other devices.

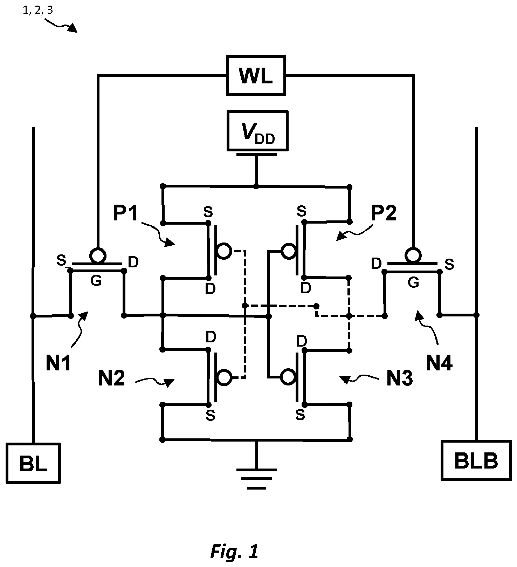

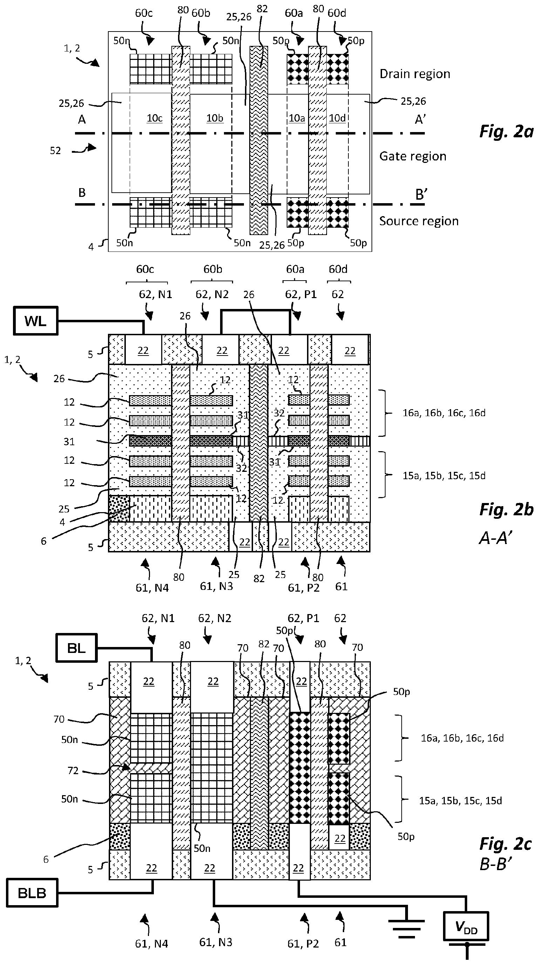

Fig. 1 illustrates the semiconductor device 1 in the form of a SRAM cell 2. Fig. 1 illustrates the SRAM cell 2 as a circuit diagram representing a latching circuit 3. The illustrated SRAM cell 2 comprises six transistors comprising four nFETs N1, N2, N3, N4 and two pFETs P1, P2. The transistors are connected to wordline WL; bitlines BL and BLB; and supply voltage V_{DD}. Figs 2a-c schematically illustrate the semiconductor device 1 arranged on a substrate 4 and show how the four nFETs N1, N2, N3, N4 and the two pFETs P1, P2 may be implemented using stacked FETs. Fig. 2a shows a top view of a first stack of FETs 60a, a second stack of FETs 60b, and a third stack of FETs 60c.

The first 60a, second 60b, and third 60c stack of FETs comprise the transistors of the SRAM cell 2 of Fig. 1, as will be discussed below. It should be noted that the illustrated FETs are implemented in a forksheet arrangement wherein the stacks of FETs are arranged in pairs and the stacks of FETs within a pair are separated by a dielectric wall 80. Thus, the second 60b, and third 60c stack of FETs are paired. Similarly, the first stack of FETs 60a is paired with a fourth stack of FETs 60d. The fourth stack of FETs 60d will not be discussed in detail in the following as it, in this particular implementation, is not part of the SRAM cell 2 formed by the first 60a, second 60b, and third 60c stack of FETs. However, the fourth stack of FETs 60d may be part of another SRAM cell 2 or other circuit.

The FETs of the first stack of FETs 60a comprise p-type source/drain regions 50p, such that the FETs of the first stack of FETs 60a are pFETs. The FETs of the second 60b and third 60c stack of FETs comprise n-type source/drain regions 50n, such that the FETs of the second 60b and third 60c stack of FETs are nFETs. Between the source/drain regions 50p, 50n of each FET there is a gate region 52, as seen in Fig. 2a. The gate regions 52 comprise the stacks of layers 10a, 10b, 10c, 10d and the gates 25, 26 discussed below. In Fig. 2a, the stacks of layers 10a, 10b, 10c, 10d are drawn with dashed lines to indicate that they may be encased in the gates 25, 26.

Fig. 2b illustrates a cross-section of the gate regions 52 along the line A-A' indicated in Fig. 2a. Fig. 2c illustrates a cross-section of the source/drain regions 50n, 50p along the line B-B' indicated in Fig. 2a.

In Figs 2b and 2c connections to WL, BL, BLB, and V_{DD} are illustrated, in accordance with Fig. 1.

As seen in Fig. 2b, each stack of FETs 60a, 60b, 60c comprises a first FET 61 and a second FET 62 stacked on top of the first FET 61. The figure indicates which of the stacked FETs correspond to P1, P2, N1, N2, N3, and N4 respectively.

Each of the first 61 and second 62 FET comprises at least one channel layer 12 for charge transport. In this illustration there are two channel layers 12 per FET. Thus, each stack of FETs 60a, 60b, 60c may be seen as having a lower section 15a, 15b, 15c, comprising the channel layers 12 of the first FET 61; and an upper section 16a, 16b, 16c, comprising the channel layers 12 of the second FET 62. Each of the first FETs 61 comprise a gate 25 extending above, to the side, and below the at least one channel layer 12 of the lower section 15a, 15b, 15c. Each of the second FETs 62 comprise a gate 26 extending above, to the side, and below the at least one channel layer 12 of the upper section 16a, 16b, 16c.

In the first 60a, second 60b, and fourth 60d stack of FETs, the gates of the first 61 and second 62 FET are separated by a dielectric layer 31, 32, said dielectric layer comprising a first 31 and second 32 portion. The gates of the first 61 FET and second 62 FET of the first 60a, second 60b, and fourth 60d stack of FETs comprise electrical contacts 22 on vertically opposite sides of the respective stack of FETs. In the illustrations, said electrical contacts 22 are embedded in an interconnect dielectric layer 5. In the illustrations, the substrate 4 on which the channel layers 12 were grown is seen between the gates of the first 61 FETs and the interconnect dielectric layer 5. Additionally, or alternatively, the semiconductor device 1 may comprise a carrier substrate 4 (not shown) supporting the stacks of FETs when part or all of the substrate 4 on which the channel layers 12 was grown is removed. In the illustrations, shallow trench isolation regions 6 are also shown.

Fig. 2b illustrates an implementation wherein the channel layers 12 of the second 62b and third 62c stack of FETs (comprising the nFETs) are wider than the channel layers 12 of the first stack of FETs 62a (comprising the pFETs).

Fig. 2c illustrates a cross-section of the source regions 50n, 50p of the stacks of FETs 60a, 60b, 60c, 60d at one end of the channel layers 12. As seen in Fig. 2a there are drain regions 50n, 50p at the opposite end of the channel layers 12. In the third stack of FETs 60c, the source region 50n at the lower section 15c is separated from the source region 50n at the upper section 16c by a dielectric spacer 72. Thus, the first 61 and second 62 FETs of the third stack of FETs 60c may be seen as having separate source regions 50n, which may be contacted separately, as shown. In the first 60s and second 60b stack of FETs, the source region 50n, 50p at the lower section 15a, 15b is merged, e.g. epitaxially merged, with the source region 50n, 50p at the upper section 16a, 16b, respectively.

In the following, the method according to the first aspect will be described. As an illustrative example, the method 100 will be described in the context of producing the SRAM cell 2 of Figs 1 and 2a-c.

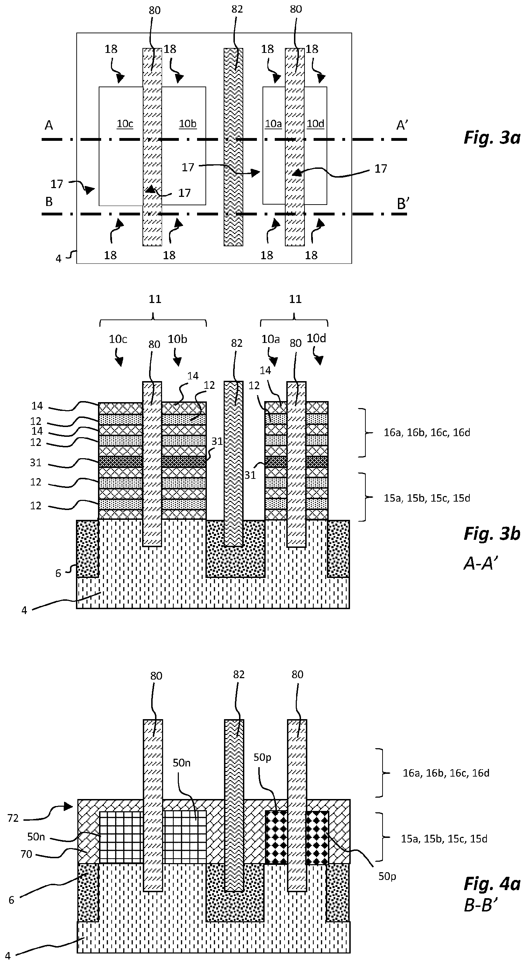

Fig. 3a-b illustrates the formation of stacks of layers 10a, 10b, 10c, 10d, formation of the first portion 31 of the dielectric layer, and formation of dielectric walls 80 and an isolation wall 82. Fig. 3a illustrates a top view of the stacks of layers 10a, 10b, 10c, 10d, each comprising two opposing lateral side 17 faces and two opposing lateral end 18 faces. Fig. 3b illustrates a cross-sectional view in what will later become the gate region A-A'. In Fig. 3b there are two pairs 11 of stacks of layers. One pair 11 of stacks of layers comprises the stacks of layers 10b, 10c for the stacks of pFETs 60b, 60c. Another pair 11 of stacks of layers comprises the stacks of layers 10a, 10d for the stacks of nFETs 60a, 60d.

A plurality of layers may be grown, e.g. epitaxially grown, e.g. grown by chemical vapor deposition (CVD) or physical vapor deposition (PVD), on a substrate 4. The substrate 4 may be a Si substrate 4. Said plurality of layers may subsequently be etched into stacks of layers 10a, 10b, 10c, 10d. In this example, a first 10a, second 10b, third 10c, and fourth 10d stack of layers are formed. Each stack of layers 10a, 10b, 10c, 10d comprises channel layers 12, and sacrificial layers 14. The channel layers 12 may be Si layers and the sacrificial layers 14 may be SiGe layers. Channel layers 12 may be separated by at least one sacrificial layer 14.

For each stack of layers 10a, 10b, 10c, 10d, one sacrificial layer 14 may be replaced by the first portion 31 of the dielectric layer. This may be done by selectively etching away the sacrificial layer 14 to be replaced (e.g. a sacrificial layer 14 comprising a high amount of Ge, in this example 30-50 at.% Ge) and depositing a dielectric material in the empty space left by said sacrificial layer 14. Said dielectric material deposited in said empty space may comprise SiO₂, or/and Si₃N₄, or/and SiOC, or/and SiOCN, or/and SiON, or/and SiC, or/and SiBCN. Said dielectric material may be deposited by atomic layer deposition.

Fig. 3b shows the stacks of layers 10a, 10b, 10c, 10d after a sacrificial layer 14 between a lower section 15a, 15b, 15c, 15d and an upper section 16a, 16b, 16c, 16d of the respective stack of layers 10a, 10b, 10c, 10d has been replaced by the first portion 31 of the dielectric layer.

Dielectric walls 80 and an isolation wall 82 may be formed. In this example, a dielectric wall 80 is formed between the first 10a and fourth 10d stack of layers and a dielectric wall 80 is formed between the second 10b and third 10c stack of layers. In the example, each such dielectric wall 80 adjoins one stack of layers to the left and another stack of layers to the right. Thus, two pairs 11 of stacks of layers are formed in the example, each with the dielectric wall 80 in between the pair 11 of stacks of layers. Further, an isolation wall 82 may be formed between the two pairs 11 of stacks of layers. In this example, such an isolation wall 82 is formed, leaving a trench between the isolation wall 82 and the nearby stack of layers. Fig. 3b shows the stacks of layers 10a, 10b, 10c, 10d after the formation of the above described dielectric walls 80 and isolation wall 82. Fig. 3b further shows that shallow trench isolation regions 6 may be formed on or in the substrate 4. The shallow trench isolation regions 6 may comprise SiO₂.

In the following, examples of dimensions for the above discussed features are given. The channel layers 12 may have a thickness of 3-10 nm. The first portion 31 of the dielectric layer may have a thickness of 10-30 nm. Thus, the sacrificial layer 14 that the first portion 31 of the dielectric layer replaces may also have a thickness of 10-30 nm. It may be beneficial to start with a sacrificial layer 14 that is thinner than the thickness of the first portion 31 of the dielectric layer as the etch not necessarily is completely selective. Thus, the sacrificial layer 14 that the first portion 31 of the dielectric layer replaces may have a thickness of 5-20 nm. The remaining sacrificial layers 14 in Fig. 3 may have thicknesses of 3-10 nm. The widths of the first 10a and fourth 10d stacks of layers, i.e. the distance between opposing side 17 faces of the first 10a and fourth 10d stacks of layers, may be 5-25 nm. This may correspond to the channel layer widths of the pFETs of the finished device. The widths of the second 10b and third 10c stacks of layers, i.e. the distance between opposing side 17 faces of the second 10b and third 10c stacks of layers, may be 5-25 nm. This may correspond to the channel layer widths of the nFETs of the finished device. A ratio between channel layer widths of the nFETs and channel layer widths of the pFETs may be between 1:1 and 2:1. For example, the channel layer widths of the pFETs may be 10 nm and the channel layer widths of the nFETs may be 15 nm. The dielectric walls 80 and isolation wall 82 may have lateral thicknesses of 6-20 nm.

Fig. 4a-c illustrates the formation of source/drain regions 50n, 50p. The source/drain regions 50n, 50p may be grown epitaxially, e.g. grown by chemical vapor deposition (CVD).

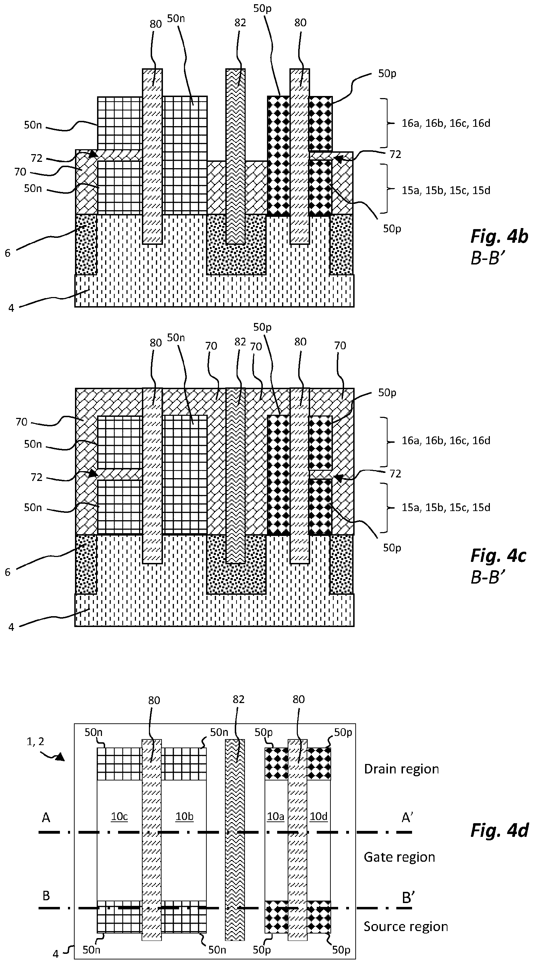

In this example, source/drain regions 50n, 50p are grown after forming the structure discussed in conjunction with Fig. 3. Fig. 4a-c are cross- sectional views along the line B-B' indicated in Fig. 2a and Fig. 4d.

Source/drain regions 50n, 50p may be grown on the end faces 18 of the stacks of layers 10a, 10b, 10c, 10d, indicated in Fig. 3. Source/drain regions 50n, 50p of the lower sections 15a, 15b, 15c, 15d may be grown before source/drain regions 50n, 50p of the upper sections 16a, 16b, 16c, 16d by masking the end faces 18 of the upper sections 16a, 16b, 16c, 16d, e.g. by a liner. The source/drain regions 50n, 50p may be doped in-situ, during epitaxial growth. N-doped source/drain regions 50n (in this example source/drain regions 50n at the second 10b and third 10c stack of layers) may be grown before p-doped source/drain regions 50p (in this example source/drain regions 50p at the first 10a and fourth 10d stack of layers), or vice versa. After growth of source/drain regions 50n, 50p of the lower sections 15a, 15b, 15c, 15d a dielectric material 70 may be deposited, the dielectric material 70 covering source/drain regions 50n, 50p of the lower sections 15a, 15b, 15c, 15d. This illustrated in Fig. 4a. The dielectric material 70 may be SiO₂ or SiOC. The dielectric material 70 may be deposited by Chemical Vapor Deposition (CVD), in particular by Flowable Chemical Vapor Deposition (FCVD). The dielectric material 70 may be arranged to form a dielectric spacer 72 on top of source/drain regions 50n, 50p at the lower sections 15a, 15b, 15c, 15d before source/drain regions at the upper sections 15a, 15b, 15c, 15d are formed, as illustrated in Fig. 4a. In other words, the dielectric material 70 may extend up to the first portion 31 of the dielectric layer between the lower sections 15a, 15b, 15c, 15d and the upper sections 16a, 16b, 16c, 16d.

The mask (e.g. liner) for the end faces 18 of the upper sections 16a, 16b, 16c, 16d may subsequently be removed before growth of the source/drain regions 50n, 50p of the upper sections 16a, 16b, 16c, 16d.

Fig. 4b illustrates that in the case source/drain regions 50n, 50p of the lower 15a, 15b, 15c, 15d and upper 16a, 16b, 16c, 16d sections are to be separated, the dielectric spacer 72 may be kept for the growth of the source/drain regions 50n, 50p of the upper sections 16a, 16b, 16c, 16d. In this example, the dielectric spacer 72 is kept for the third 10c and fourth 10d stacks of layers.

Fig. 4b illustrates that in the case source/drain regions 50n, 50p of the lower 15a, 15b, 15c, 15d and upper 16a, 16b, 16c, 16d sections are to be merged, the dielectric spacer 72 may be recessed before the growth of the source/drain regions 50n, 50p of the upper sections 16a, 16b, 16c, 16d. In this example, the dielectric spacer 72 is removed for the first 10a and second 10b stacks of layers. The dielectric spacer 72 may be recessed in any way. The dielectric spacer 72 may be removed. The dielectric spacer 72 may be recessed, e.g. by etching. Regions where the dielectric spacer 72 should not be removed may be masked, e.g. by lithographic patterning.

Fig. 4c illustrates that after formation of the source/drain regions 50n, 50p of the lower 15a, 15b, 15c, 15d and upper 16a, 16b, 16c, 16d sections, further dielectric material 70 may be deposited to cover also the source/drain regions 50n, 50p of the upper 16a, 16b, 16c, 16d sections. The dielectric material 70 may then be polished, e.g. by chemical mechanical polishing, to facilitate further lithography.

Fig. 4d is a top view of the stacks of layers 10a, 10b, 10c, 10d after formation of the source/drain regions 50n, 50p. For illustrational clarity, the dielectric material 70 is not shown.

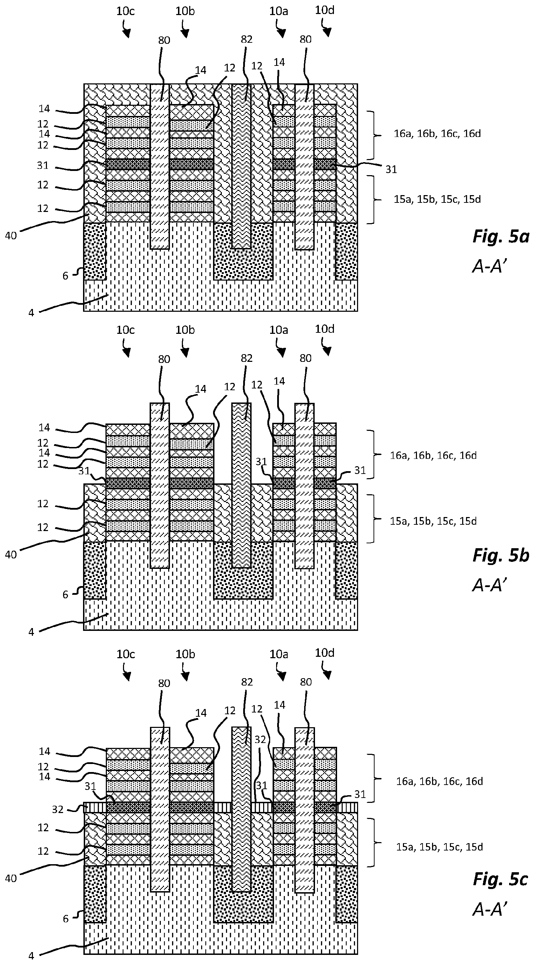

Fig. 5a-c illustrates the formation of the sacrificial structure 40 and the second portion 32 of the dielectric layer. Figs 5a-c are cross-sectional views along the line A-A' indicated in Fig. 2a.

In this example, the sacrificial structure 40 and the second portion 32 of the dielectric layer are formed after the formation of the source/drain regions 50n, 50p, discussed in conjunction with Fig. 4.

Material for the sacrificial structure 40 may be provided up to a level of the first portion 31 of the dielectric layer. Thus, the sacrificial structure 40 may serve as a dummy gate for a replacement gate process. The material for the sacrificial structure 40 may comprise amorphous silicon or polycrystalline silicon. Material for the sacrificial structure 40 may be deposited up to a level above the first portion 31 of the dielectric layer, as shown in Fig. 5a. The material for the sacrificial structure 40 may subsequently be etched back to the level of the first portion 31 of the dielectric layer, as shown in Fig. 5b.

A top layer of the material provided for the sacrificial structure 40 may subsequently be oxidized to form the second portion 32 of the dielectric layer, as shown in Fig. 5c. Thus, the second portion 32 of the dielectric layer may comprise oxidized amorphous silicon or oxidized polycrystalline silicon. The second portion 32 of the dielectric layer may have a thickness of 3-30 nm. The second portion 32 of the dielectric layer may have the same thickness as the first portion 31 of the dielectric layer, e.g. 10-30 nm. Alternatively, the second portion 32 of the dielectric layer may be thinner than the first portion 31 of the dielectric layer. The second portion 32 of the dielectric layer may have a thickness of 3-10 nm. The second portion 32 of the dielectric layer may extend laterally from a side 17 of the stack of layers 10a, 10b, 10c, 10d to an isolation wall 82, as shown in Fig. 5c.

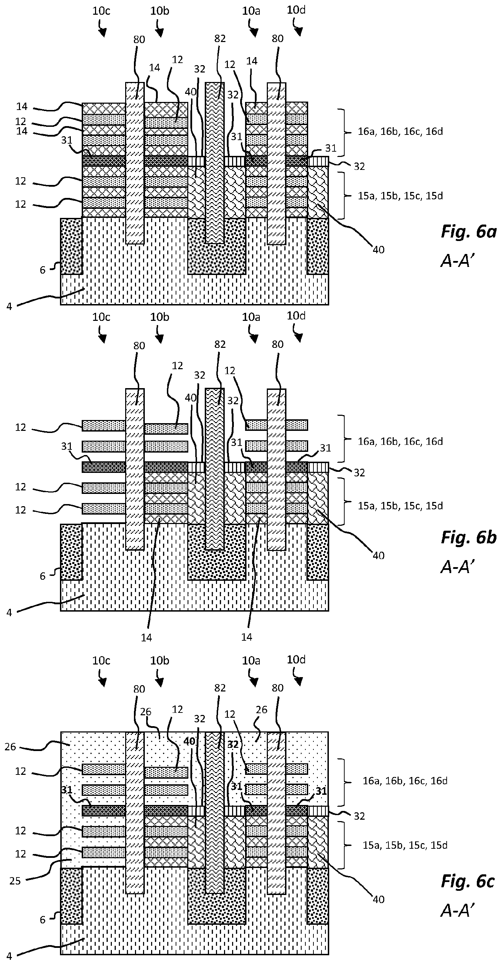

Fig. 6a-c illustrates gate 26 formation at the upper section 16a, 16b, 16c, 16d. Fig. 6a-c also illustrates gate 25 formation at the lower section 15c where a common gate is implemented, in this figure at the third stack of layers 10c. Figs 6a-c are cross-sectional views along the line A-A' indicated in Fig. 2a.

In this example, the gates 25,26 are formed after the formation of the sacrificial structure 40 and the second portion 32 of the dielectric layer, discussed in conjunction with Fig. 5. The gates 25, 26 may be metal gates.

For the stacks of layers where a common gate should be implemented (in this example the third stack of layers 10c), the second portion 32 of the dielectric layer may be removed. Further the sacrificial structure 40 supporting said second portion 32 of the dielectric layer may also be removed. This is illustrated in Fig. 6a. The second portion 32 of the dielectric layer and the sacrificial structure 40 may be removed by etching. For the stacks of layers where the second portion 32 of the dielectric layer should not be removed (in this example the first, second and fourth stacks of layers 10a, 10b, 10d), the second portion 32 of the dielectric layer may be masked.

The sacrificial layers 14 may then be removed, e.g. by etching, as shown in Fig. 6b. Channel layers 12 which are not anymore supported by sacrificial layers 14 may at this point be suspended between source/drain regions 50n, 50p.

Gates 25, 26 may subsequently be formed, as shown in Fig. 6c. The gates 25, 26 may herein replace the removed sacrificial layers 14. The gates 25, 26 may also replace removed sacrificial structures 40. The gates 25, 26 may be formed by first depositing a gate dielectric layer, e.g. a high-k dielectric, conformally coating the exposed channel layers 12. Subsequently, a gate work function metal (WFM) may be deposited on the gate dielectric layer. The gate dielectric layer is, for illustrational clarity, not individually shown in the figures but it may be situated at the interface between the gates 25, 26 and the channel layers 12 in the figures. The WFM used for gates 25, 26 intended for pFETs may be different from the WFM used for gates 25, 26 intended for nFETs.

The gate dielectric layer may be formed of a conventional a high-k dielectric e.g. HfO2, HfSiO, LaO, AlO or ZrO. Each WFM may be formed of one or more effective WFMs (e.g. an n-type WFM such as TiAl or TiAlC and/or a p-type WFM such as TiN or TaN). The gate dielectric layer and the first WFM may be deposited by atomic layer deposition (ALD).

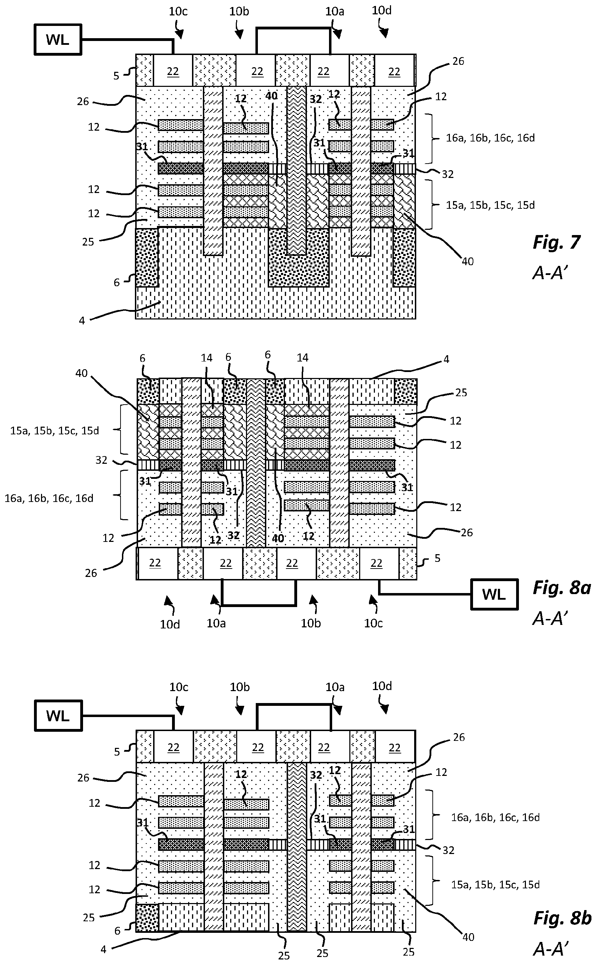

Fig. 7 illustrates contact 22 formation at the upper sections 16a, 16b, 16c, 16d. Figs 7 is a cross-sectional view along the line A-A' indicated in Fig. 2a.

In this example, the contacts 22 at the upper sections 16a, 16b, 16c, 16d are formed after the formation of the gates 26 at the upper section 16a, 16b, 16c, 16d, discussed in conjunction with Fig. 6.

An interconnect dielectric layer 5 may be deposited and patterned to form openings to the gates 26 of the upper sections 16a, 16b, 16c, 16d. Contacts 22 may then be formed in said openings, e.g. by depositing metal in the opening, after which the contacts 22 may be interconnected in accordance with the desired electrical circuit. Fig. 7 illustrates contacts 22 to the gates 26 of the upper sections 16a, 16b, 16c, 16d. Contacts to the source/drain regions 50n, 50p of the upper sections 16a, 16b, 16c, 16d may be formed analogously.

Fig. 8a-b illustrates gate 25 formation at the lower sections 15a, 15b, 15d where a common gate is not previously implemented (in this figure at the first 10a, second 10b, and fourth 10d stack of layers). Figs 8a-b are cross-sectional views along the line A-A' indicated in Fig. 2a. The gate formation illustrated in Fig. 8a-b is an example of backside processing.

In this example, the gates 25 at the lower sections 15a, 15b, 15d where a common gate is not previously implemented are formed after the formation of the contacts 22 at the upper sections 16a, 16b, 16c, 16d, discussed in conjunction with Fig. 7.

The backside of the substrate 4 used for formation of the stacks of layers 10a, 10b, 10c, 10d may be removed to gain access to the lower sections 15a, 15b, 15c, 15d. This may be include bonding the interconnect dielectric layer 5 above the upper sections 16a, 16b, 16c, 16d to a carrier substrate. Fig. 8a illustrates the removal of the backside of the substrate 4. For illustrational clarity, the carrier substrate is not shown. The backside of the substrate 4 may be removed e.g. by grinding and/or back side etch. Simultaneously, parts of the shallow trench isolation 6 may be removed. During the removal of the backside of the substrate 4, the semiconductor device may be flipped upside down, e.g. to facilitate grinding and/or backside etch. Thus, Fig. 8a is drawn upside down.

Remaining sacrificial structures 40 and sacrificial layers 14 of the lower sections 15a, 15b, 15c, 15d may be removed, e.g. by etching, e.g. after removal of obstructing shallow trench isolation regions 6. Gates 25 of the lower sections 15a, 15b, 15c, 15d may subsequently be formed, as shown in Fig. 8b. The gates 25 may herein replace the above mentioned removed structures. Gates 25 of the lower sections 15a, 15b, 15c, 15d may be formed analogously to the gates 26 of the upper sections 16a, 16b, 16c, 16d, discussed in conjunction with Fig. 6.

Finally, contacts 22 at the lower sections 15a, 15b, 15c, 15d may be formed, both for the gates 25 of the lower sections 15a, 15b, 15c, 15d and the source/drain regions 50n, 50p of the lower sections 15a, 15b, 15c, 15d. The contacts 22 may then be interconnected in accordance with the desired electrical circuit. In this example, the final device may be that of Figs 2a-c, wherein each stack of layers 10a, 10b, 10c, 10d has been converted into a stack of FETs 60a, 60b, 60c, 60d.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor device (1), the method comprising:
forming a plurality of stacks of layers (10a, 10b) on a substrate (4), the stacks of layers being laterally spaced apart, each stack of layers (10a, 10b) comprising channel layers (12) of semiconductor material separated by sacrificial layers (14), the plurality of stacks of layers (10) comprising at least a first stack of layers (10a) and a second stack of layers (10b), each stack of layers (10a, 10b) having a lower (15a, 15b) and an upper (16a, 16b) section, the lower (15a, 15b) and upper (16a, 16b) section each comprising at least one channel layer (12);
forming, for each stack of layers (10a, 10b), a dielectric layer associated with the stack of layers (10a, 10b), the dielectric layer comprising:
a first portion (31) arranged between the lower (15a, 15b) and upper (16a, 16b) section of the associated stack of layers (10a, 10b); and
a second portion (32) extending laterally from a side (17) of the associated stack of layers (10a, 10b), the second portion (32) being supported by a sacrificial structure (40);
for the respective upper sections (16a, 16b) of the first (10a) and second (10b) stacks of layers:
forming a gate (26) extending above, to the side, and below the at least one channel layer (12) of the upper section (16a, 16b), said gate replacing sacrificial layers (14) above and below the at least one channel layer (12) of the upper section (16a, 16b);
for the respective lower sections (15a, 15b) of the first (10a) and second (10b) stack of layers:
forming another gate (25) extending above, to the side, and below the at least one channel layer (12) of the lower section (15a, 15b), said gate (25) replacing sacrificial layers (14) above and below the at least one channel layer (12) of the lower section (15a, 15b) and the sacrificial structure (40) supporting the second portion (32) of the dielectric layer, wherein the gate (25) of the lower (15a, 15b) section and the gate (26) of the upper (16a, 16b) section are electrically contacted on vertically opposite sides of the stack of layers (10a, 10b);
converting each stack of layers (10a, 10b) into a stack of field-effect transistors (60a, 60b), FETs, each stack of FETs (60a, 60b), comprising a first FET (61) at the lower section (15a, 15b) of the stack of layers (10a, 10b) and a second FET (62) at the upper section (16a, 16b) of the stack of layers (10a, 10b), the first stack of layers (10a) being converted into a first stack of FETs (60a), the first (61) and second (62) FETs of the first stack of FETs being p-type FETs, the second stack of layers (10b) being converted into a second stack of FETs (60b), the first (61) and second (62) FETs of the second stack of FETs (60b) being n-type FETs.

2. The method of claim 1, wherein the channel layers (12) of the second stack of layers (10b) are wider than the channel layers (12) of the first stack of layers (10a).

3. The method of claim 1 or 2, wherein, for each stack of layers (10a, 10b), the first (31) and second (32) portion of the associated dielectric layer are made of different materials.

4. The method of any one of the preceding claims, wherein, for each stack of layers (10a, 10b), forming the dielectric layer associated with the stack of layers (10a, 10b) comprises:
forming the first portion (31) of the dielectric layer by replacing a sacrificial layer of the stack of layers (10a, 10b) with dielectric material.

5. The method of any one of the preceding claims, wherein, for each stack of layers (10a, 10b), forming the dielectric layer associated with the stack of layers (10a, 10b) comprises:
forming the second portion (32) of the dielectric layer by:
providing material for the sacrificial structure (40), up to a level of the first portion (31) of the dielectric layer;
oxidizing a top layer of the material provided for the sacrificial structure (40) to form the second portion (32) of the dielectric layer supported by the sacrificial structure (40).

6. The method of any one of the preceding claims, wherein the sacrificial structure (40) comprises amorphous silicon or polycrystalline silicon.

7. The method of any one of the preceding claims, further comprising
forming, by epitaxial growth, for each section (15a, 15b) of each stack of layers (10a, 10b), source/drain regions (50n, 50p) being arranged at opposite ends of the channel layers (12) of the sections (15a, 15b),
wherein a dielectric spacer (72) is formed on top of source/drain regions (50n, 50p) at the lower section (15a, 15b) before source/drain regions (50n, 50p) at the upper section (16a, 16b) are formed.

8. The method of any one of the preceding claims,
wherein, for at least one stack of layers (10a, 10b), the dielectric spacer (70) at the lower section (15a, 15b) is recessed again at one end of the channel layers (12) before source/drain regions (50n, 50p) at the upper section (16a, 16b) are formed, such that, at said end of the channel layers (12), the source/drain regions (50n, 50p) are epitaxially merged.

9. The method of any one of the preceding claims, wherein the plurality of stacks of layers comprises a third stack of layers (10c), the third stack of layers (10c) being converted into a third stack of FETs (60c),wherein the method comprises:
providing a common gate (25, 26) of the first and second FETs of the third stack of FETs by, for the third stack of layers (10c):
removing the second portion (32) of the dielectric layer extending laterally from the side of the third stack of layers (10c); and
forming a gate (25, 26) extending above, to the side, and below the at least one channel layer of the both the lower (15c) and upper (16c) sections of the third stack of layers (10c), such that said gate simultaneously controls the channel layers (12) of both the lower (15c) and upper (16c) sections of the third stack of layers (10c), said gate (25, 26) replacing sacrificial layers (14) above and below each channel layer (12) of the lower (15a, 15b) and upper (16a, 16b) sections and the sacrificial structure (40) previously supporting the removed second portion (32) of the dielectric layer.

10. The method of any one of the preceding claims, further comprising:
forming a dielectric wall (80), the dielectric wall (80) adjoining one stack of layers to the left and another stack of layers to the right, such that a pair (11) of stacks of layers is formed with the dielectric wall (80) in between;
wherein, for each stack of layers of the pair (11) of stacks of layers, the gates of the lower and upper sections are formed to extend to the side of the stack of layers that is opposite to the dielectric wall (80).

11. The method of claim 10, wherein the pair (11) of stacks of layers is converted into a pair of stacks of FETs, wherein
all FETs of the pair of stacks of FETs are p-type; or
all FETs of the pair of stacks of FETs are n-type.

12. The method of any one of the preceding claims, further comprising:
forming a latching circuit (3) configured to store one bit by connecting FETs of the stacks of FETs (60).

13. A semiconductor device (1), arranged on a substrate (4), the semiconductor device (1) comprising at least a first (60a) and a second (60b) stack of field effect transistors, FETs, each stack of FETs (60a, 60b) comprising
a first FET (61) and a second FET (62) stacked on top of the first FET (61), each of the first and second FET comprising at least one channel layer (12) for charge transport and a gate (25, 26), the gate (25, 26) extending above, to the side, and below the at least one channel layer (12), wherein the channel layers (12) of the first (61) and second (62) FETs are parallel with each other and parallel with the substrate (4);
wherein, for each of the first and second stack of FETs,
the gates (25, 26) of the first (61) and second (62) FET are separated by a dielectric layer;
the gates (25, 26) of the first FET and second FET are electrically contacted on vertically opposite sides of the stack of FETs;
wherein the first (61) and second (62) FETs of the first stack of FETs (60a) are p-type FETs and the first (61) and second (62) FETs of the second stack of FETs (60b) are n-type FETs.

14. The semiconductor device (1) of claim 13, wherein the channel layers (12) of the second stack of FETs (60b) are wider than the channel layers (12) of the first stack of FETs (60a).

15. The semiconductor device (1) of claim 13 or 14, wherein, for each stack of FETs (60a, 60b), the dielectric layer comprises:
a first portion (31) between the at least one channel layer (12) of the first FET (61) and the at least one channel layer (12) of the second FET (62); and
a second portion (32) between the gate (25) extending to the side of the at least one channel layer (12) of the first FET (61) and the gate (26) extending to the side of the at least one channel layer (12) of the second FET (62);
wherein the first (31) and second (32) portion of the dielectric layer are made of different materials.
